# EUROPÄISCHE PATENTANMELDUNG

(11) **EP 1 286 279 A1**
(43) Veröffentlichungstag der Anmeldung: **26.02.2003**
(21) Anmeldenummer: 01440278.8
(22) Anmeldetag: 21.08.2001
(51) Int. Cl.: G06F 17/50

(54) **Konfigurations tool**

(71) Anmelder: ALCATEL, 75008 Paris (FR)
(72) Erfinder: Meyer, Jürgen, 70567 Stuttgart (DE)
(74) Vertreter: Menzietti, Domenico, Dipl.-Ing

(57) **Zusammenfassung**

Aufgabe der Erfindung ist es, eine optimierte Entwicklung einer Prozessorplattform für eine integrierte Schaltung bereitzustellen. Das erfindungsgemäße Konfigurations Tool zur automatischen Generierung mindestens eines Software Files und/oder mindestens eines Hardware Files für eine spezielle Prozessorplattform (CleanDMEP) für eine integrierten Schaltung, insbesondere einen ASIC oder ein System-on-Chip, wobei die Prozessorplattform (CleanDMEP) mindestens einen Prozessor (17) und mindestens ein Modul (3, 13, 14) beinhaltet, die über einen Bus (AMBA-AHB) miteinander verbunden sind, beinhaltet mindestens einen auswählbaren Parameter für mindestens einen Prozessor und mindestens ein Modul, und generiert das mindestens eine Software File und/oder das mindestens eine Hardware File in Abhängigkeit von den ausgewählten Parametern.

## Beschreibung

Die Erfindung betrifft ein Konfigurations Tool.

Integrierte Schaltungen sind z.B. als System-on-Chip auf einem ASIC ausgeführt; ASIC = Application Specific Integrated Circuit. Ein ASIC beinhaltet spezielle Schaltkreise, die an Kundenwünsche adaptiert sind. Diese erfüllen spezielle Aufgaben. In der Telekommunikation dienen sie beispielsweise der Verarbeitung von VolP- Signalen, DSL-, ATM-, SDH-, SONET, UMTS-, GSM-, LMDS- oder ISDN-Signalen; VolP = Voice over Internet Protocol, DSL = Digital Subscriber Line, ATM = Asynchronous Transfer Mode, SDH = Synchronous Digital Hierarchy, SONET = Synchronous Optical Network, UMTS = Universal Mobile Telekommunikation System, GSM = General System Mobile, LMDS = Local Multipoint Digital System, ISDN = Integrated Services Digital Network. Sie dienen somit der Verarbeitung von Sprache, Daten, Video, Internet-Webpages, etc.

Eine integrierte Schaltung hat z.B. eine spezielle Prozessorplattform zur Ausführung von generellen, aber auch applikationsspezifischen Aufgaben. Diese Prozessorplattform kann für beliebige Anwendungen genutzt werden; die selbe Prozessorplattform beispielsweise in DSL-Chips, ATM-Chips, etc. Sie beinhaltet einen Prozessor und stellt Rechenkapazität zur Verfügung.

Die Prozessorplattform hat mehrere Bausteine, wobei einige Bausteine an einen schnellen AMBA-AHB Bus angeschlossen sind, z.B. ein Prozessor, ein ROM Controller, ein RAM Controller, und andere Bausteine an einen langsamen AMBA-APB Bus angeschlossen sind, z.B. ein Interrupt Controller, ein Real Time Counter; ROM = Read Only Memory, RAM = Random Access Memory. Der Frage welcher Baustein an welchen Bus angeschlossen wird, hängt von der Zugriffgeschwindigkeit, der Verarbeitungsgeschwindigkeit und der Häufigkeit der Verwendung des Bausteins ab.

Bei der Entwicklung eines ASIC muss auch die Prozessorplattform stets neu entwickelt werden, angepasst auf die speziellen Anforderungen, die an den ASIC gestellt werden. Dies ist zeitaufwendig. Bei manchen integrierten Schaltungen, z.B. FPGA mit integrierter Prozessorplattform, wird ein vorab festgelegter Prozessortyp mit einer bestimmten Verarbeitungsgeschwindigkeit verwendet, sowie eine fest vorgegebene Konfiguration einer Plattform, d.h. Anzahl und Art der Peripheriebausteine und Größe des internen RAM und ROM sind nicht wählbar; FPGA = Free Programmable Gate Array. Das FPGA kann zwar erweitert werden, so dass ein gewisser Freiheitsgrad entsteht und eine Anpassung an Anforderungen für eine bestimmte Applikation nachträglich erfüllt werden können. Doch ist der Freiheitsgrad insofern eingeschränkt, dass durch die Wahl des Prozessors die Verarbeitungsgeschwindigkeit nicht verändert werden kann. Zudem könnte die vorgegebene Konfiguration der Peripheriebausteine hinsichtlich der Speichergröße, Performance und Interfaces ungeeignet oder unzureichend sein.

Alternativ kann die Prozessorplattform auf die Anforderungen des ASIC optimiert werden. Dazu ist aber in jedem Einzelfall eine Neuentwicklung der Prozessorplattform notwendig. Dies ist zum einen sehr zeitaufwendig. Zum anderen ist jede Neuentwicklung sehr fehleranfällig, so dass es mehrerer Anläufe bedarf für Test, Entfernen von Software- und/oder Hardwarefehlern, etc.

Aufgabe der Erfindung ist es, eine optimierte Entwicklung einer Prozessorplattform für eine integrierte Schaltung bereitzustellen.

Gelöst wird diese Aufgabe durch ein Konfigurations Tool nach Anspruch 1. Das Software Konfigurations Tool eröffnet die Möglichkeit durch Eingabe von gewünschten Parametern, z.B. Anzahl der Prozessoren, Auswahl der Prozessortypen, Auswahl des Bedarfs an Speicher Controllern, eine auf die Applikation der integrierten Schaltung zugeschnitte Prozessorplattform zu generieren. Mittels z.B. einer GUI (Graphical User Interface) werden dem Konfigurationstool die relevanten Parameter für die Entwicklung einer Prozessorplattform übermittelt, die an einen speziellen ASIC gestellte Anforderungen erfüllt. Das Konfigurations Tool überprüft, ob eine sinnvolle Auswahl der Parameter erfolgt ist, d.h. eine Prozessorplattform unter den gewählten Randbedingungen möglich ist, und generiert bei einer sinnvollen Auswahl VHDL Files in Abhängigkeit von den Parametern, von Modul Bibliothek Files und Schablonen Files. Die generierten VHDL Files werden dazu verwendet, die Prozessorplattform auf dem ASIC zu erstellen. Zusätzlich wird vom Konfigurations Tool in vorteilhafter Weise ein Software Boot File sowie Test Files generiert. Mittels des Boot Files wird der Prozessor auf der generierten Prozessorplattform gebooted. Mittels der Test Files werden die Grundfunktionen der Prozessorplattform überprüft. Sowohl Boot als auch Test werden automatisch durchgeführt, so dass die Prozessorplattform direkt verwendet werden kann um z.B. ASIC spezifische Verarbeitungen durchzuführen.

Die Modul Bibliothek ist durch Hinzufügung einzelner neuer Module aus einfache Art und Weise erweiterbar. Das Konfigurations Tool erkennt automatisch das neue Modul und bindet es selbständig in den Konfigurations Prozess ein.

Das generische Software Konfigurations Tool dient z.B. zur automatischen Generierung von VHDL Files für eine Prozessorplattform eines ASIC. Die Prozessorplattform stellt die allgemeine Rechenkapazität für den ASIC zur Verfügung. Diese beträgt z.B. ca. 20% der Funktionalität des ASIC. Ein Benutzer kann eine applikationsspezifische Prozessorplattform nach seinen Vorgaben spezifizieren. Durch die anschließende automatische Generierung der Prozessorplattform spart der Benutzer erheblich Zeit ein und verringet erheblich die Entwicklungskosten. Bei einer bevorzugten Ausgestaltung der Erfindung können spezielle, vom Benutzer spezifizierte oder beispielsweise als Standardkonfigurationen bereits vorbekannte Konfigurationen abgespeichert werden. Diese abgespeicherten Konfigurationen können dann auf einfache Art und Weise unverändert wiederverwendet werden oder durch Veränderungen eines oder mehr Parameter verändert wiederverwendet werden, wodurch auf einfache Art und Weise ein Redesign einer Prozessorplattform ermöglicht wird werden.

Vorteilhafte Ausgestaltungen sind den abhängigen Ansprüchen und der nachfolgenden Beschreibung zu entnehmen.

Im folgenden wird die Erfindung anhand eines Ausführungsbeispiels und unter Zuhilfenahme von Figuren erläutert. Es zeigen:
- Fig. 1: einen schematisch dargestellten Ausschnitt aus einer erfindungsgemäßen integrierten Schaltung,
- Fig. 2: einen schematisch dargestellten Ablauf einer VHDL Files Generierung unter Verwendung des erfindungsgemäßen Konfigurations Tools,
- Fig. 3: ein Beispiel einer Auswahl von Parametern über eine GUI,
- Fig. 4: ein zweites Beispiel einer Auswahl von Parametern über eine GUI,
- Fig. 5: ein drittes Beispiel einer Auswahl von Parametern über eine GUI,
- Fig. 6: ein viertes Beispiel einer Auswahl von Parametern über eine GUI.

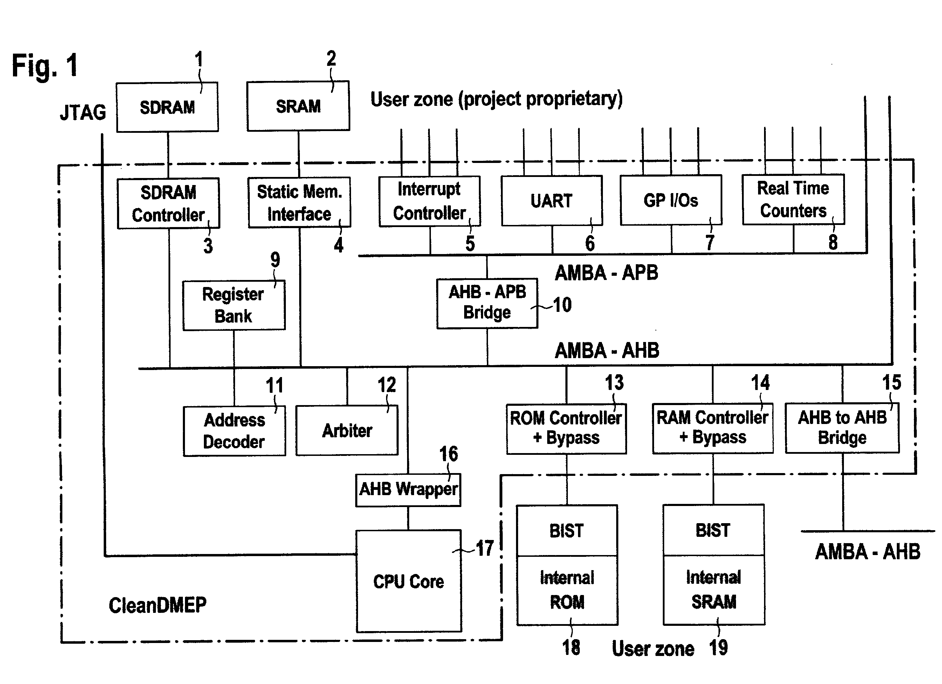

Fig. 1 zeigt einen schematisch dargestellten Ausschnitt aus einer erfindungsgemäßen integrierten Schaltung.

Der Ausschnitt zeigt eine mit CleanDMEP bezeichnete Prozessorplattform und mehrere mit der Prozessorplattform verbundene Module; CleanDMEP = Clean Design Methodology for Embedded Processors. Die Prozessorplattform ist eine allgemeine Plattform und kann für beliebige Verarbeitungen eingesetzt werden, z.B. in der Telekommunikation, im Maschinenbau, in der Luft- und Raumfahrt, etc; in der Telekommunikation beispielsweise bei allen Formen des XDSL, bei UMTS, VolP, etc.

Die integrierte Schaltung ist z.B. als ASIC oder System-on-Chip ausgeführt. Sie beinhaltet zum einen die spezielle Prozessorplattform mit einem Prozessor 17, drei AHB Master und/oder Slave Module 3, 13, 14 und eine zentrale Registerbank 9, die über einen Bus AMBA-AHB miteinander verbunden sind. Modul 3 ist z.B. als SDRAM Controller ausgeführt, Modul 13 als ROM Controller und Modul 14 als RAM Controller. Die Registerbank 9 beinhaltet die drei Steuerregister für die drei Module 3, 13, 14. Jedes Modul 3, 13, 14 hat über den Bus AMBA-AHB Zugriff auf das ihm zugeordnete Register. Der Bus ist z.B. als schneller Bus ausgelegt, z.B. als AMBA-AHB Bus.

Im folgenden wird der allgemeine Aufbau der Prozessorplattform erläutert.

Die Prozessorplattform beinhaltet ein als SDRAM Controller ausgeführtes Modul 3, das zum einen mit dem schnellen, internen Bus AMBA-AHB verbunden ist und zum anderen mit einem internen, aber außerhalb der Prozessorplattform angeordneten SDRAM 1. Intern bedeutet innerhalb der integrierten Schaltung, extern außerhalb der integrierten Schaltung. Der SDRAM Controller steuert den Zugriff aufs SDRAM 1 und führt die erforderliche Konversion aufs Busprotokoll durch. Das SDRAM 1 kann auch außerhalb der integrierten Schaltung angeordnet werden, also extern.

Die Prozessorplattform beinhaltet ferner einen Static Memory Interface 4, das zum einen mit dem schnellen, internen Bus AMBA-AHB verbunden ist und zum anderen mit einem internen, aber außerhalb der Prozessorplattform angeordneten SRAM 2. Das Static Memory Interface 4 steuert den Zugriff aufs SRAM 2 und führt die erforderliche Konversion aufs Busprotokoll durch. Das SRAM 2 kann auch außerhalb der integrierten Schaltung angeordnet werden, also extern.

Ferner ist ein Interrupt Controller 5 vorgesehen, der zum einen mit einem langsamen, internen, z.B. als AMBA-APB ausgeführten Bus verbunden ist und zum anderen mindestens eine Schnittstelle zu einem internen oder externen, aber außerhalb der Prozessorplattform angeordneten Modul aufweist. Der Interrupt Controller 5 dient dazu, Interrupts von Modulen auserhalb der Plattform mit dem Prozessor zu verbinden.

Ferner ist ein UART 6 vorgesehen, der zum einen mit dem langsamen, internen AMBA-APB Bus verbunden ist und zum anderen eine Schnittstelle zu einem externen Host-Prozessor, der aber außerhalb der Prozessorplattform angeordnet ist, aufweist. Der UART 6 dient dazu, Daten zwischen dem externen Host Prozessor und dem internen Prozessor (17) zu uebertragen.

Ferner ist ein GP I/O 7 vorgesehen, der zum einen mit dem langsamen, internen AMBA-APB Bus verbunden ist und zum anderen mindestens eine Schnittstelle zu einem internen oder externen, aber außerhalb der Prozessorplattform angeordneten Modul aufweist. Der GP I/O 7 dient dazu, Steuerinformationen zwischen Modulen auserhalb der Plattform und dem interenen Prozessor (17) zu uebertragen; GP I/O = General Purpose In/Out.

Ferner ist ein Real Time Counter 8 vorgesehen, der zum einen mit dem langsamen, internen AMBA-APB Bus verbunden ist und zum anderen mindestens eine Schnittstelle zu einem internen oder externen, aber außerhalb der Prozessorplattform angeordneten Modul aufweist. Der Real Time Counter 8 dient als Timer, der mit dem Systemclock laeuft.

Des weiteren ist eine Register Bank 9 vorgesehen, die mit dem schnellen AMBA-AHB Bus verbunden ist. Die Register Bank 9 stellt Register für mehrere Module zur Verfügung, darunter z.B. RAM Controller 14 und SDRAM Controller 3.

Ein Arbiter 12, der mit dem schnellen AMBA-AHB Bus verbunden ist, dient dazu, bei gleichzeitigem Zugriff mehrerer Master auf den schnellen Bus, diese Zugriffe zu priorisieren und in der priorisierten Reihenfolge abzuarbeiten.

Der Prozessor 17 ist z.B. als Mikroprozessor oder als Digitaler Signalprozessor ausgeführt. Er ist eventuell über einen AHB Wrapper mit dem schnellen AMBA-AHB Bus verbunden. Der AHB Wrapper 16 führt bei Bedarf die nötige Konversion der Protokolle durch.

Das Modul 13 ist z.B. als ROM Controller ausgeführt, der zum einen mit dem schnellen AMBA-AHB Bus verbunden ist und zum anderen mit einem außerhalb der Prozessorplattform angeordneten internen ROM 18, das auch ein BIST enthalten kann; BIST = Build-In Self Test.

Der ROM Controller steuert den Zugriff aufs interne ROM 18 und führt die erforderliche Konversion aufs Busprotokoll durch.

Das als RAM Controller ausgeführte Modul 14 ist zum einen mit dem schnellen, internen Bus AMBA-AHB verbunden und zum anderen mit einem internen, aber außerhalb der Prozessorplattform angeordneten SRAM 19. Der RAM Controller steuert den Zugriff aufs SRAM 19 und führt die erforderliche Konversion auf Busprotokoll durch. Das SRAM 19 kann auch ein BIST enthalten.

Ferner ist eine Brücke 10 vorgesehen. Brücke 10 verbindet den schnellen AMBA-AHB Bus mit dem langsamen AMBA-APB Bus. Über die Brücke 10 wird somit eine Verbindung zwischen den am AMBA-AHB Bus angeschlossenen Modulen und den am AMBA-APB Bus angeschossenen Modulen hergestellt. So hat Prozessor 17 über Brücke 10 z.B. Zugriff auf den Interrupt Controller 5. Die Aufteilung mit zwei Bussen mit unterschiedlichen Verarbeitungsgeschwindigkeiten hat den Vorteil, dass langsame Zugriffe nicht schnelle Zugriffe behindern. Brücke 10, AMBA-APB Bus und die daran angeschlossenen Module sind optional. Werden die Funktionalitäten der Module nicht benötigt können sie und der AMBA-APB Bus sowie die Brücke 10 beim Design weggelassen werden, was zu einer Platzeinsparung und zur Reduzierung von Herstellungskosten führt.

Der Prozessor 17 hat einen Verbindung zu einem JTAG= Joint Test Action Group. Das JTAG Interface kann zum Debuggen der SW auf dem internen Prozessor verwendet werden, aber auch waehrend der Fertigungskontrolle des ASICs.

Der AMBA-APB Bus kann intern, außerhalb der Prozessorplattform weitergeführt sein und gegebenenfalls auch extern, außerhalb der integrierten Schaltung.

Der AMBA-AHB Bus kann intern, außerhalb der Prozessorplattform weitergeführt sein und gegebenenfalls auch extern, außerhalb der integrierten Schaltung.

Im Ausführungsbeispiel ist eine spezielle Prozessorplattform dargestellt. Die Erfindung kann auf jede Prozessorplattform angewendet werden, insbesondere eine Prozessorplattform mit weniger oder mehr Elementen als die in der Fig. dargestellte. Die integrierte Schaltung kann auch mehr als einen Prozessor, mehr als einen Steuereingang und mehr als einen externen Speicher aufweisen. Sind beispielsweise zwei Prozessoren über eine gemeinsame Adressverwaltung verwaltet, so können ein Steuereingang und ein externer Speicher für beide Prozessoren ausreichend sein. Außer der speziellen Prozessorplattform können auf der integrierten Schaltung noch weitere Prozessoren und Module angeordnet sein, die auch den Großteil der integrierten Schaltung, z.B. 80%, ausmachen können, so dass z.B. nur 20% auf die Prozessorplattform entfällt. Die integrierte Schaltung kann auch zwei oder mehr Prozessorplattformen beinhalten.

Im Ausführungsbeispiel sind die Module als ROM-, RAM- und SDRAM-Controller ausgeführt. Ein Modul kann z.B. auch ein DRAM, PROM, EPROM oder EEPROM ausgeführt sein; PROM = Programmable ROM, EPROM = Erasable PROM.

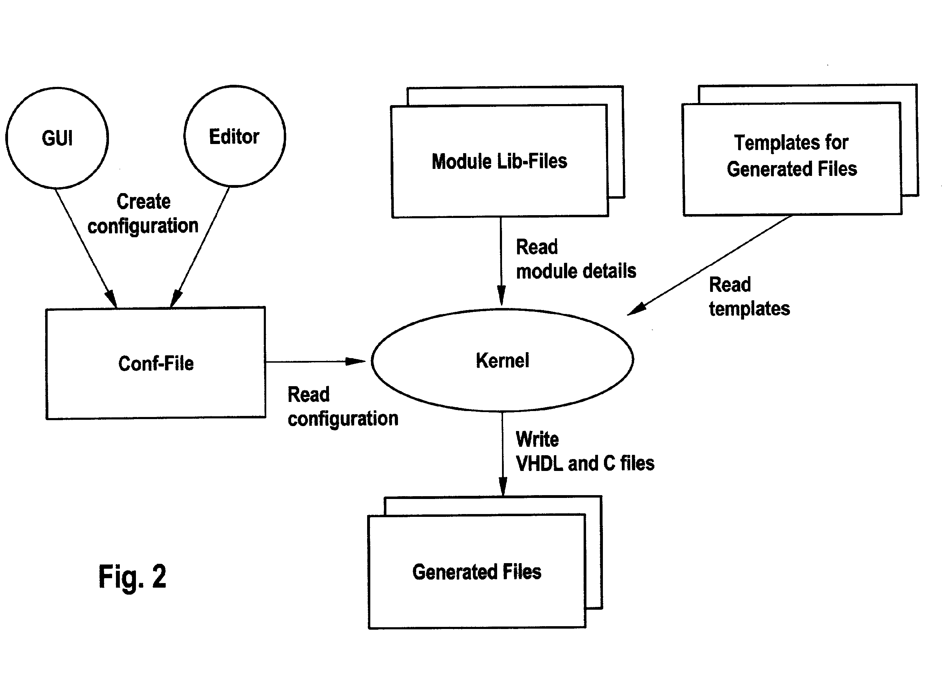

Fig. 2 zeigt einen schematisch dargestellten Ablauf einer VHDL Files Generierung unter Verwendung des erfindungsgemäßen Konfigurations Tools. Die VHDL Files werden z.B. verwendet zur Herstellung einer Prozessorplattform wie in Fig. 1 dargestellt.

Ein Prozessor Kernel eines Computers, z.B. einer UNIX-Maschine, führt das Konfigurations Tool aus, das zur Generierung der VHDL Files drei Komponenten benötigt: ein vom Benutzer, z.B. mit Hilfe des GUI, erstelltes Konfigurations File Conf-File, die Modul Biliothek Files Module Lib-Files und die Schablonen Files Templates for Generated Files.

Das Konfigurations File beinhaltet auswählbare Parameter, die z.B. über eine GUI oder einen Editor auswählbar sind. Sind alle gewünschten Parameter ausgewählt, kann ein Icon Check Constraints (siehe Fig. 2) angeklickt werden, woraufhin durch das Konfigurations Tool überprüft wird, ob die ausgewählten Parameter eine sinnvolle Gesamtkonfiguration ergeben oder z.B. physikalische oder sonstige Unmöglichkeiten der Realisierung der Auswahl widersprechen. Durch Anklicken eines Icons Generate all Files (siehe Fig. 2) kann das Generieren der Generated Files:
VHDL Files, Boot Files und Test Files gestartet werden. Der Prozessor Kernel liest dann die ausgewählte Konfiguration aus dem Konfigurations File und verknüpft diese mit gelesenen modulspezifischen Modul Details aus den Module Bibliothek Files und gelesenen Schablonen aus den Schablonen Files. Durch diese Verknüpfung werden die VHDL Files generiert. In den Schablonen Files sind neben konfigurationsunabhängigen Programmschritten Schlüsselworte enthalten, die durch die Modul Details mit den ausgewählten Parametern ersetzt werden. Mittels der VHDL Files wird dann bei einem Chip Hersteller die integrierte Schaltung beinhaltend die ausgewählte Prozessorplattform hergestellt. Die ausgewählte Prozessorplattform ist z.B. eine RISC Prozessorplattform.

Das Konfigurations Tool generiert z.B. Software und Hardware Files, darunter z.B. VHDL Top-Level Files, Module Specific VHDL Files, Packages, C-Code Files und Header Files. Die VHDL Top-Level Files beinhalten die Verdrahtung aller Module und die Packages enthalten u.a. Konstantendefinitionen. In den C-Code und Header-Files werden Konstanten und Datenstrukturen für die Software definiert.

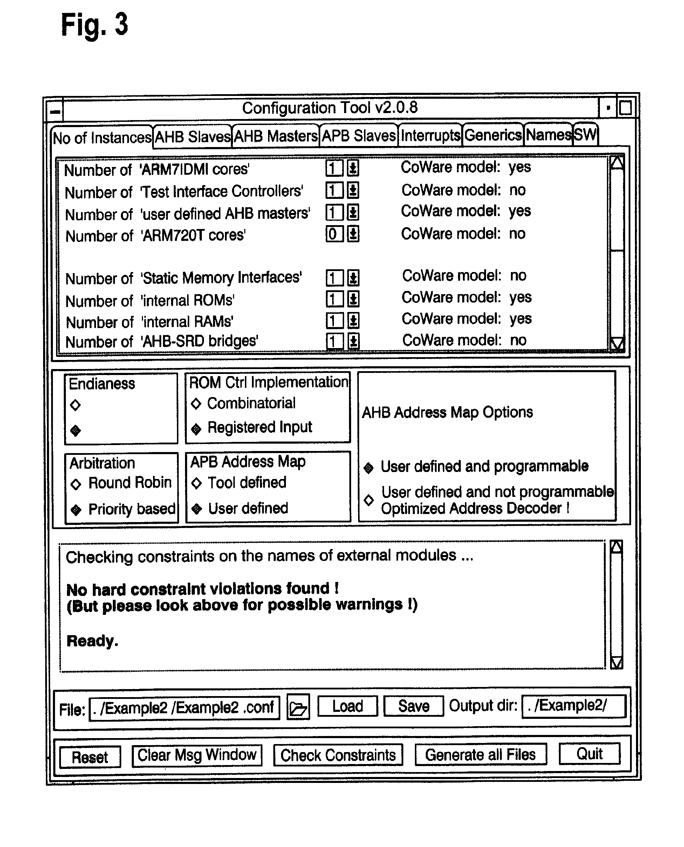

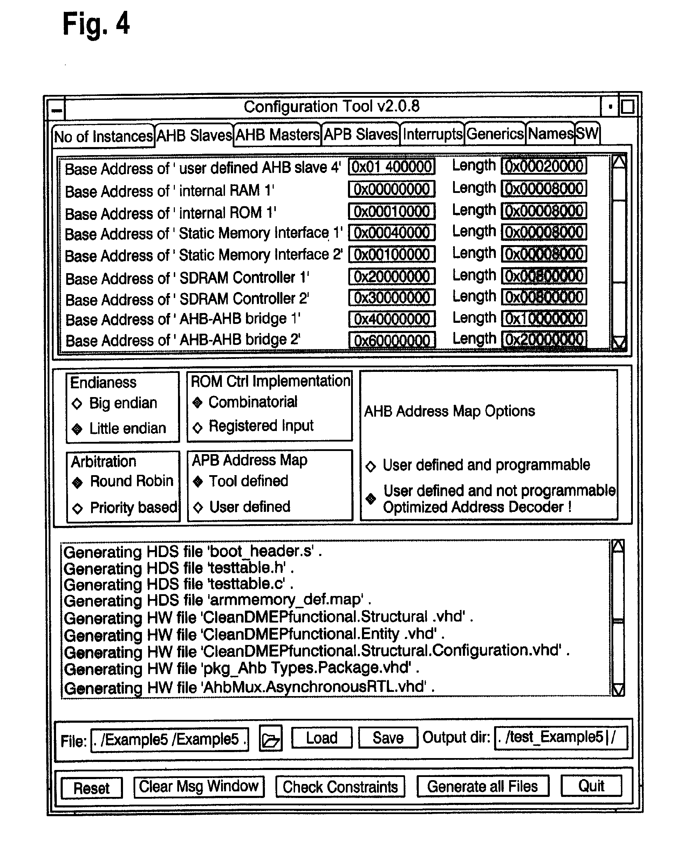

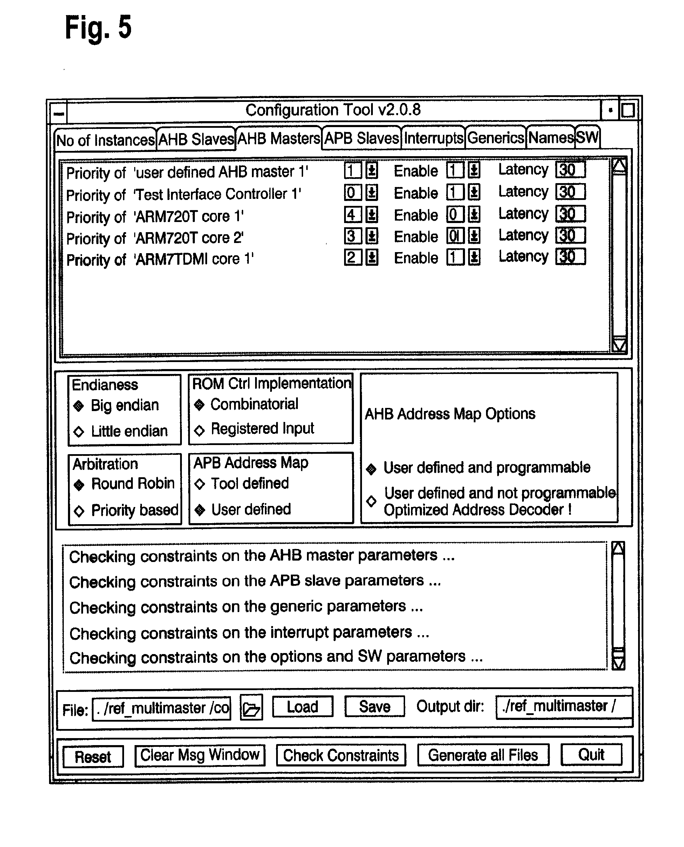

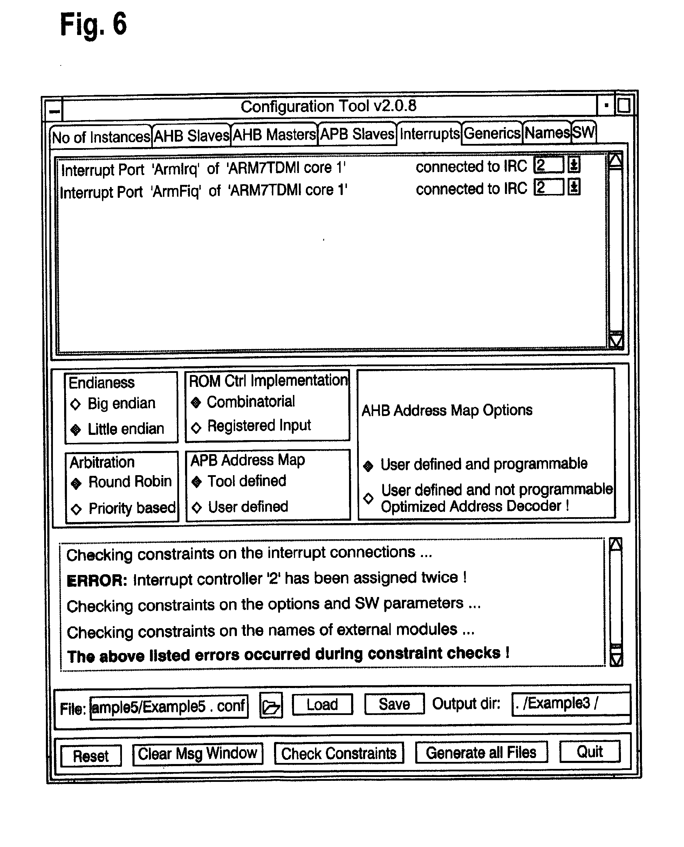

Fig. 3 bis 6 zeigen Beispiele einer Auswahl von Parametern über eine GUI.

Als Parameter sind z.B. vorgesehen: Anzahl und Typ der Prozessoren, z.B. verschiedene ARM Prozessoren, Anzahl der Test Interface Controller, Anzahl der benutzerdefinierten AHB Busse, Anzahl der Static Memory Interfaces, Anzahl der internen ROMs, Anzahl der internen RAMs, Anzahl der AHB-APB Brücken.

Des weiteren sind als Parameter z.B. vorgesehen:
- die Art der Arbitration: Round Robin oder Priority based,
- die Art der ROM Control Implementation: Combinatirial oder Registered Input,
- die Art der Address Map: Tool defined oder User defined,
- die Addressbereiche der Module,
- die Prioritäten und initiale Aktivierung der Prozessoren,
- die Verbindung von Interrupt Controllern zu Prozessoren,
- die Definition von modulspezifischen Generics,
- Register-Addressen der Module, die mit dem AMBA-APB Bus verbunden sind, falls vorhanden,
- Auswahl des Speichers, der die Boot-Software beinhaltet und des Fall-Back Speichers.

Beim Ausführungsbeispiel sind chipintern AMBA Busse verwendet und chipextern AMBA Busse und/oder ein PCI Bus. Chipintern können z.B. auch verwendet werden: CoreConnect Bus, CoreFrame Bus, FISPbus oder IPbus. Chipextern können z.B. auch verwendet werden: VMEbus, USB Bus, usw. Anstelle eines oder zwei Busse zur chipinternen Verbindung der Bausteine können auch drei oder mehr Busse verwendet werden, z.B. ein Extra-Bus für die Verknüpfung des Arbiters mit mehreren Bausteinen.

Abkürzungen:
AMBA = Advanved Micro-controller Bus Architecture,
AHB = Advanced High-performance Bus,
APB = Advanced Peripheral Bus,
ARM = Advanced RISC Machine,
VHDL = VHSIC Hardware Description Language.

## Patentansprüche

1. Konfigurations Tool zur automatischen Generierung mindestens eines Software Files und/oder mindestens eines Hardware Files für eine spezielle Prozessorplattform (CleanDMEP) für eine integrierten Schaltung, insbesondere einen ASIC oder ein System-on-Chip, wobei die Prozessorplattform (CleanDMEP) mindestens einen Prozessor (17) und mindestens ein Modul (3, 13, 14) beinhaltet, die über einen Bus (AMBA-AHB) miteinander verbunden sind, wobei das Tool mindestens einen auswählbaren Parameter für mindestens einen Prozessor und mindestens ein Modul beinhaltet, und wobei die Generierung des mindestens einen Software Files und/oder des mindestens einen Hardware Files in Abhängigkeit von den ausgewählten Parametern erfolgt.

2. Konfigurations Tool nach Anspruch 1, **dadurch gekennzeichnet, dass** das Tool geeignet ist, VHDL Files für die spezielle Prozessorplattform (CleanDMEP) aus den Parametern, Modul Bibliothek Files und Schablonen Files zu generieren.

3. Konfigurations Tool nach Anspruch 2, **dadurch gekennzeichnet, dass** das Tool geeignet ist, die VHDL Files zu generieren durch Auswahl der Module mit den ausgewählten Parametern aus der Modul Bibliothek und Einsetzen der ausgewählten Module in vordefinierte Stellen der Schablonen.

4. Konfigurations Tool nach Anspruch 3, **dadurch gekennzeichnet, dass** das Tool geeignet ist, zu den generierten VHDL Files zugehörige Software Boot Files zum Booten des mindestens einen Prozessors zu generieren.

5. Konfigurations Tool nach Anspruch 1, **dadurch gekennzeichnet, dass** ein auswählbarer Parameter eine Auswahl der Anzahl der Prozessoren, eine Auswahl der Prozessortypen und/oder eine Auswahl des Bedarfs an Speicher Controllern ermöglicht.

6. Computer beinhaltend ein Konfigurations Tool nach Anspruch 1.

7. Computer nach Anspruch 6, **dadurch gekennzeichnet, dass** eine GUI vorhanden ist, zur Darstellung des mindestens einen auswählbaren Parameters.

8. Speichermedium mit abgespeichertem Konfigurations Tool nach Anspruch 1.

9. GUI zur Bereitstellung einer Schnittstelle zu einem Konfigurations Tool zur automatischen Generierung mindestens eines Software Files und/oder mindestens eines Hardware Files für eine spezielle Prozessorplattform (CleanDMEP) für eine integrierten Schaltung, insbesondere einen ASIC oder ein System-on-Chip, wobei die GUI mindestens ein Icon zur Auswahl mindestens eines Parameters für mindestens einen Prozessor und mindestens ein Modul beinhaltet.
